# EUROPEAN PATENT SPECIFICATION

(11) **EP 3 321 976 B1**
(45) Date of publication and mention of the grant of the patent: **18.11.2020**
(21) Application number: 16821103.5
(22) Date of filing: 19.05.2016
(51) Int. Cl.: H01L 31/05, B32B 15/04, H01L 31/054, H05K 1/02

(54) **FLEXIBLE PRINTED WIRING BOARD, CONCENTRATING SOLAR POWER GENERATION MODULE, CONCENTRATING SOLAR POWER GENERATION PANEL, AND METHOD FOR MANUFACTURING FLEXIBLE PRINTED WIRING BOARD**
FLEXIBLE LEITERPLATTE, KONZENTRIERENDES SONNENENERGIEERZEUGUNGSMODUL, KONZENTRIERENDES SONNENENERGIEERZEUGUNGSPANEEL UND VERFAHREN ZUR HERSTELLUNG EINER FLEXIBLEN LEITERPLATTE
CARTE DE CIRCUIT IMPRIMÉ FLEXIBLE, MODULE DE PRODUCTION D'ÉNERGIE SOLAIRE À CONCENTRATION, PANNEAU DE PRODUCTION D'ÉNERGIE SOLAIRE À CONCENTRATION, ET PROCÉDÉ DE FABRICATION DE CARTE DE CIRCUIT IMPRIMÉ FLEXIBLE

(30) Priority: 09.07.2015 JP 2015137836
(43) Date of publication of application: 16.05.2018
(73) Proprietor: Sumitomo Electric Industries, Ltd., Osaka-shi, Osaka 541-0041 (JP)
(72) Inventor: TOYA, Kazumasa, Osaka-shi, Osaka 554-0024 (JP); NAGAI, Youichi, Osaka-shi, Osaka 554-0024 (JP); SAITO, Kenji, Osaka-shi, Osaka 554-0024 (JP); IWASAKI, Takashi, Osaka-shi, Osaka 554-0024 (JP)
(74) Representative: Boult Wade Tennant LLP
(86) International application number: PCT/JP2016/064907
(87) International publication number: WO 2017/006632

(56) References cited:
- JP-A- S58 111 206
- JP-A- 2009 147 155
- JP-A- 2009 147 155
- JP-A- 2013 149 831
- JP-A- 2013 149 831
- JP-A- 2013 535 100
- US-A1- 2014 230 883
- US-A1- 2015 255 655

## Description

### TECHNICAL FIELD

The present invention relates to a flexible printed circuit, a concentrated photovoltaic module, a concentrated photovoltaic panel, and a method for manufacturing the flexible printed circuit. This application claims priority to Japanese Patent Application No. 2015-137836 filed July 9, 2015.

### BACKGROUND ART

To date, concentrated photovoltaic apparatuses are known that are configured to obtain a desired generated power by means of a concentrated photovoltaic panel in which a large number of concentrated photovoltaic modules are vertically and horizontally arrayed (see PATENT LITERATURE 1, for example).

The power generation module that is used in the power generating apparatus according to PATENT LITERATURE 1 includes, in a vessel-shaped housing, a flexible printed circuit having power generating elements, and generates power at the power generating elements by concentrating sunlight onto the power generating elements by means of condenser lenses provided on the upper-surface side of the housing.

US-2014/230883 describes a flexible printed circuit comprising a solar cell on a flexible substrate of the printed circuit and a concentrating portion for concentrating incident light onto the solar cell.

### CITATION LIST

### [PATENT LITERATURE]

PATENT LITERATURE 1: Japanese Laid-Open Patent Publication No. 2013-80760

### SUMMARY OF INVENTION

A flexible printed circuit according to the present invention includes the features claimed in claim 1.

A concentrated photovoltaic module according to the present invention includes:
a housing having a mounting surface;
the above-described flexible printed circuit to be joined to the mounting surface; and a lens element mounted to the housing so as to correspond to the power generating element, the lens element configured to concentrate sunlight on the power generating element.

A concentrated photovoltaic panel according to the present invention is formed by assembling a plurality of the above-described concentrated photovoltaic modules.

A method for manufacturing a flexible printed circuit according to the present invention includes the steps claimed in method claim 8.

### BRIEF DESCRIPTION OF DRAWINGS

[FIG. 1] FIG. 1 is a perspective view showing a concentrated photovoltaic apparatus according to one embodiment of the present invention.
[FIG. 2] FIG. 2 is a perspective view (partially cut out) of an enlarged view of a concentrated photovoltaic module.
[FIG. 3] FIG. 3 is an enlarged view of a portion III shown in FIG. 2.
[FIG. 4] FIG. 4 is a schematic view of a partial cross-section of the concentrated photovoltaic module, at a portion where a power generating element is provided.
[FIG. 5] FIG. 5 illustrates the comparison between a cross-section of a flexible printed circuit according to the present embodiment and that according to conventional art.

### DESCRIPTION OF EMBODIMENTS

### [TECHNICAL PROBLEM]

The flexible printed circuit according to PATENT LITERATURE 1 includes: a conductive layer made of copper connected to a power generating element; and an insulating layer which insulates the conductive layer from the housing side, and has some flexibility so as to be able to be mounted to the housing in close contact therewith. In order to facilitate handling during the manufacture thereof, a reinforcing plate for giving the flexible printed circuit some rigidity is provided on the rear-surface side of the insulating layer. This reinforcing plate is formed of an aluminum material having a heat dissipating property in order to release heat from the power generating element and the conductive layer, to the housing side.

However, the reinforcing plate formed of the aluminum material has to be thick in order to ensure a sufficient heat dissipating property, which makes it difficult to reduce the weight and the like of the flexible printed circuit.

In addition, the conductive layer made of copper and the reinforcing plate made of aluminum have different coefficients of thermal expansion from each other. Thus, due to the difference in thermal expansion at the time of joining these by heat pressing or the like, variation in their dimensions is likely to occur. Then, when cutting out a flexible printed circuit having a desired shape from an intermediate material which is obtained by joining the conductive layer, the insulating layer, and the reinforcing plate, it is necessary to take into consideration cutting conditions for both the conductive layer and the reinforcing plate which are formed of different materials, respectively. Therefore, in actual practice, a manufacturing method is adopted in which the conductive layer and the insulating layer, and the reinforcing plate are separately cut into desired shapes, respectively, and then joined together. In this case, the number of steps required for the manufacturing is increased, and alignment at the time of the joining is difficult. Further, in a case where the rigidity of the reinforcing plate is low, the joining by heat pressing or the like after the cutting is difficult. Therefore, not only in terms of the heat dissipating property as described above but also in terms of the manufacturing, the reinforcing plate has to be formed thick to increase the rigidity thereof.

An object of the present invention is to solve the problem and the like in terms of the manufacturing as described above, to increase manufacturability.

### [ADVANTAGEOUS EFFECTS OF INVENTION]

According to the present invention, manufacturability of the flexible printed circuit can be increased.

### [Summary of the embodiment]

The summary of the embodiment of the present invention includes at least the following.
(1) A flexible printed circuit according to an embodiment is a flexible printed circuit for a concentrated photovoltaic module, the flexible printed circuit including:
   a conductive layer to which a power generating element is connected; an insulating layer having an insulating property; and a reinforcing layer for reinforcing the insulating layer, the conductive layer, the insulating layer, and the reinforcing layer being joined together in this order, wherein
   the reinforcing layer is formed of a material identical to that of the conductive layer.

   With this configuration, the coefficients of thermal expansion of the reinforcing layer and the conductive layer are identical to each other. Thus, even if layers including these layers are joined together by heat pressing or the like, variation in dimensions is less likely to occur. In addition, since the reinforcing layer and the conductive layer can be worked on the same condition, the layers including these layers can be easily worked into a desired shape in a state of being joined together. It should be noted that the flexible printed circuit according to this embodiment does not exclude the presence of another layer between the conductive layer and the insulating layer and between the insulating layer and the reinforcing layer. For example, an adhesive layer may be provided between the conductive layer and the insulating layer and between the insulating layer and the reinforcing layer.
(2) The conductive layer and the reinforcing layer may be made of copper.
   In a case where the reinforcing layer is made of copper, the thermal conductivity thereof is higher than that of a conventional reinforcing layer made of aluminum. Thus, the reinforcing layer can be formed thin with the heat dissipating property ensured. Therefore, the weight of the flexible printed circuit can be reduced.
(3) One surface of the reinforcing layer to be joined to the insulating layer has been subjected to blackening treatment.
   Accordingly, the joining strength between the reinforcing layer and the insulating layer can be increased.
(4) Preferably, the thickness of the reinforcing layer is set in a range from 30 to 140 µm.
   This is because: if the thickness of the reinforcing layer is smaller than this range, the heat dissipating property and the effect of reinforcement are reduced; and if the thickness of the reinforcing layer is greater than this range, the effects of weight reduction, flexibility, and cost reduction are reduced.
(5) A protection layer covering a surface of the conductive layer to which the power generating element is connected may be provided in a manner of avoiding the power generating element.
   With this configuration, the conductive layer is protected by the protection layer, and thus, the durability thereof is increased, and in addition, occurrence of electric leakage can be prevented.
(6) An adhesive layer for joining the reinforcing layer to a housing of a concentrated photovoltaic module may be provided on a surface of the reinforcing layer opposite to the surface of the reinforcing layer to which the insulating layer is joined.
   With this configuration, the work of bonding and mounting the flexible printed circuit to the housing of the concentrated photovoltaic module can be performed quickly and easily.
(7) A concentrated photovoltaic module according to an embodiment includes:
   a housing having a mounting surface; the flexible printed circuit according to any one of (1) to (6) above to be joined to the mounting surface; and a lens element mounted to the housing so as to correspond to a power generating element of the flexible printed circuit, the lens element configured to concentrate sunlight on the power generating element.
   With this configuration, it is possible to provide a concentrated photovoltaic module having good manufacturability.
(8) A concentrated photovoltaic panel according to an embodiment is formed by assembling a plurality of the concentrated photovoltaic modules according to (7) above.
   With this configuration, it is possible to provide a concentrated photovoltaic panel having good manufacturability.
(9) A method for manufacturing a flexible printed circuit according to an embodiment includes the steps of:
   forming an intermediate material of a flexible printed circuit for a concentrated photovoltaic module, by joining a conductive layer to which a power generating element is connected, an insulating layer having an insulating property, and a reinforcing layer which is formed of a material identical to that of the conductive layer and which is for reinforcing the insulating layer; and
   cutting the intermediate material into a desired shape.

With this configuration, since the conductive layer and the reinforcing layer are made of an identical material, layers including these layers can be easily cut into a desired shape in a state of being joined together. Thus, the number of manufacturing steps can be reduced, and the manufacturing cost can be reduced. Since the layers including the conductive layer and the reinforcing layer, which are joined together in advance, are cut into a desired shape, the rigidity required for the reinforcing layer during the cutting can be reduced. Thus, the reinforcing layer can be made thin.

### [Details of embodiments]

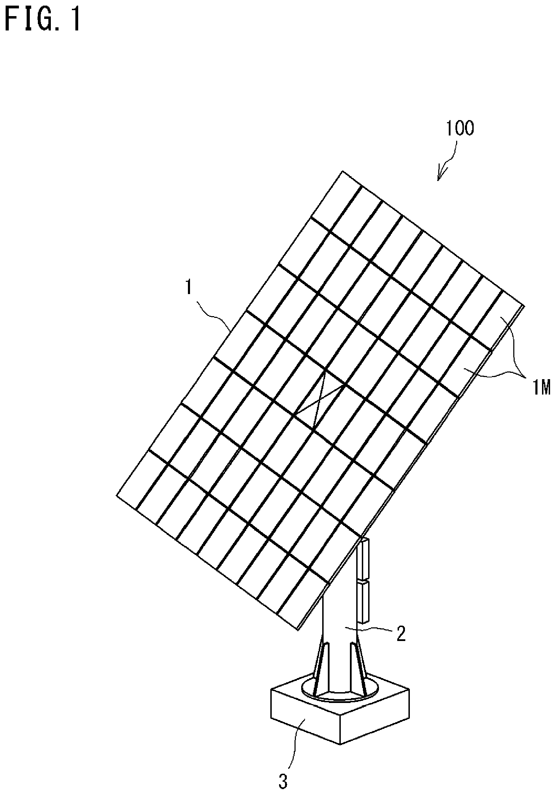

FIG. 1 is a perspective view showing a concentrated photovoltaic apparatus according to one embodiment of the present invention.

In FIG. 1, a concentrated photovoltaic apparatus 100 includes: a concentrated photovoltaic panel 1; a post 2 which supports the concentrated photovoltaic panel 1 at the center on the rear surface thereof; and a base 3 on which the post 2 is mounted.

The concentrated photovoltaic panel 1 is formed by vertically and horizontally assembling 62 (7 in length × 9 in breadth - 1) concentrated photovoltaic modules 1M, excluding the center portion used for connection to the post 2, for example.

One concentrated photovoltaic module 1M has a rated output of about 120 W, for example, and then, the entirety of the concentrated photovoltaic panel 1 has a rated output of about 7.5 kW.

The photovoltaic panel 1 can be rotated by a rotation mechanism not shown in two directions of azimuth and elevation, with the post 2 used as the axis. The concentrated photovoltaic panel 1 can be caused to track the sun while always facing the direction of the sun.

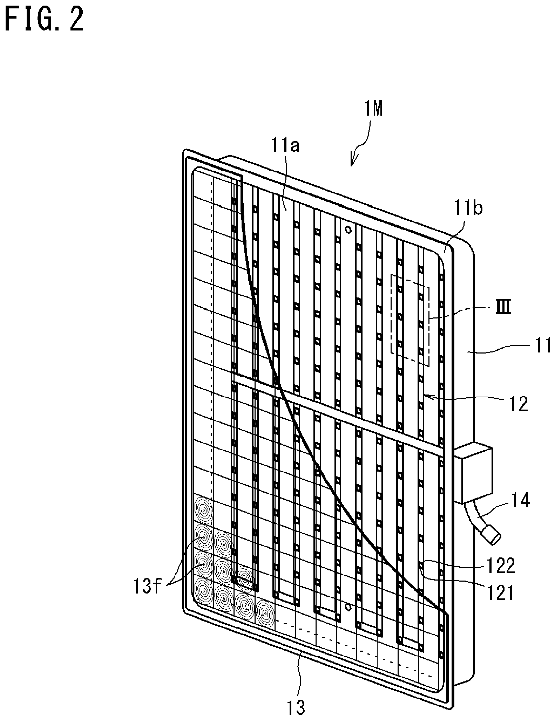

FIG. 2 is a perspective view (partially cut out) showing an enlarged view of the concentrated photovoltaic module (hereinafter, also simply referred to as module) 1M.

The module 1M includes, as main components: a housing 11 in a vessel shape (vat shape) having a bottom plate 11a; a flexible printed circuit 12 provided in contact with the upper surface (mounting surface) of the bottom plate 11a; and a primary concentrating portion 13 mounted to a flange portion 11b in such a manner as to close the opening portion of the housing 11. The housing 11 is made of metal, and preferably, made of aluminum. Being made of metal, the housing 11 has a good thermal conductivity. Thus, heat dissipation from the flexible printed circuit 12 to the housing 11 is especially good. With respect to the dimensions of the module 1M, the length, the width, and the depth can be 840 mm, 640 mm, 85 mm, respectively, for example.

The primary concentrating portion 13 is a Fresnel lens array, and is formed by arranging, in a matrix shape, a plurality of (for example, 16 in length × 12 in breadth, 192 in total) Fresnel lenses 13f serving as lens elements which concentrate sunlight. The primary concentrating portion 13 can be obtained by, for example, forming a silicone resin film on a rear surface (inside) of a glass plate used as a base material. Each Fresnel lens 13f is formed on this resin film. On the external surface of the housing 11, a connector 14 for taking out an output from the module 1M is provided.

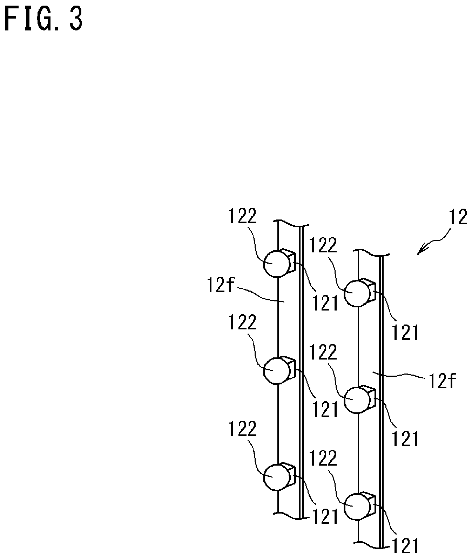

FIG. 3 is an enlarged view of a portion III shown in FIG. 2. In FIG. 3, the flexible printed circuit 12 includes: a flexible substrate 12f having a ribbon shape; power generating elements (solar cells) 121 provided on the upper surface thereof; and secondary concentrating portions 122 provided so as to cover the power generating elements 121. Sets of the power generating element 121 and the secondary concentrating portion 122 are provided at positions corresponding to the Fresnel lenses 13f of the primary concentrating portion 13, by the same number of the Fresnel lenses 13f. Each secondary concentrating portion 122 concentrates sunlight incident from its corresponding Fresnel lens 13f onto the power generating element 121. The secondary concentrating portion 122 is a lens, for example. In the present embodiment, a spherical lens is used, but the lens may have a shape other than the spherical shape. Alternatively, instead of a lens, a reflecting mirror may be used that guides light downwardly while reflecting the light irregularly.

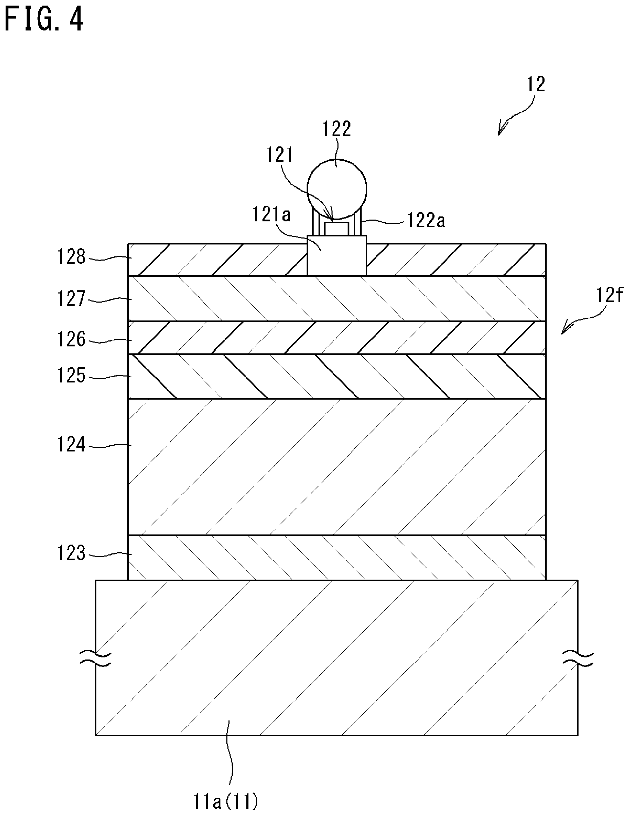

FIG. 4 is a schematic view of a partial cross-section of the module 1M, at a portion where the power generating element 121 is provided.

The flexible substrate 12f includes, when an adhesive layer and the like are considered as a part thereof: an adhesive layer 123; a reinforcing plate (reinforcing layer) 124; an adhesive layer 125; an insulating base material (insulating layer) 126; a pattern (conductive layer) 127; and a cover lay (protection layer) 128, from the bottom in this order. The flexible printed circuit 12 is formed by integrating the layers forming the flexible substrate 12f, the power generating element 121, and the secondary concentrating portion 122. It should be noted that the thicknesses of the respective layers 123 to 128 shown in FIG. 4 are substantially proportional to their actual thicknesses.

The power generating element 121 has a lead frame 121a which is an output terminal, and the lead frame 121a is electrically connected to a predetermined portion of the pattern 127. The reference sign 122a in FIG. 4 denotes a support body which supports the secondary concentrating portion 122 on the power generating element 121.

The pattern 127 is made of a copper foil, for example, and is formed on the insulating base material 126 by etching or the like.

The insulating base material 126 is made of polyimide which is excellent in heat resistance, for example. The pattern 127 is insulated from the housing 11 by the insulating base material 126.

The lowest adhesive layer 123 bonds to the bottom plate 11a of the housing 11 and to the reinforcing plate 124. The adhesive layer 123 has electrical conductivity so as to maintain the housing 11 and the reinforcing plate 124 at the same electric potential (ground potential). The adhesive layer 123 is composed of a double sided tape, for example, and is mounted to the lower surface of the reinforcing plate 124 in advance, in a state where the flexible printed circuit 12 is not yet mounted to the housing 11.

The other adhesive layer 125 bonds to the reinforcing plate 124 and to the insulating base material 126. Specifically, the reinforcing plate 124 and the insulating base material 126 are joined together via the adhesive layer 125 by heat pressing. The insulating base material 126 and the pattern 127 form the flexible substrate 12f in a narrow sense.

The cover lay 128 which covers the pattern 127 is a layer made of an insulating material, and is excellent in withstand voltage. The cover lay 128 can be made of a synthetic resin such as polyimide, for example. The cover lay 128 is joined to the pattern 127 in close contact therewith by thermal welding. The cover lay 128 protects the pattern 127 by covering it, and, in addition, prevents occurrence of electric leakage.

The thermal conductivity of the cover lay 128 is set to be about 0.2 [W/m·K]. By the thermal conductivity of the cover lay 128 being set to be comparatively low, conduction of heat of sunlight can be suppressed. From this point of view, preferably, the cover lay 128 has a "white"-based color which has a high reflectance against sunlight.

The reinforcing plate 124 provides a slight rigidity to the flexible printed circuit 12 to such an extent that the flexible printed circuit 12 does not lose flexibility. This facilitates handling of the flexible printed circuit 12 during manufacture and the like of the power generation module 1M. In addition, by the reinforcing plate 124, an effect of preventing deformation of the entire flexible printed circuit 12 can be obtained, and thus, the shape of the pattern 127 can be maintained.

The reinforcing plate 124 according to the present embodiment is made of copper. Thus, the reinforcing plate 124 has an excellent thermal conductivity (heat dissipating property) for dissipating heat from the power generating element 121, the pattern 127 and the like, to the bottom plate 11a of the housing 11.

Table 1 shows a recommended value and an applicable range for the thickness of each layer in the flexible printed circuit 12. The listing order in the up-down direction of the layers in table 1 corresponds to the stacking order in the up-down direction of the layers shown in FIG. 4.

**[Table 1]**

| Member | Thickness (µm) | |
|---|---|---|
| | Recommended value | Applicable range |
| Cover lay | 25 | 5 to 40 |
| Pattern | 35 | 9 to 35 |
| Insulating base material | 25 | 10 to 30 |
| Adhesive layer | 35 | 10 to 300 |
| Reinforcing plate | 105 | 30 to 140 |
| Adhesive layer | 35 | 10 to 300 |
| Housing (bottom plate) | 800 | 800 to 1000 |

The reinforcing plate 124 according to the present embodiment is made of copper, and from the point of view of heat dissipating property and reinforcement, a desirable thickness thereof is 105 µm. On the other hand, the reinforcing plate of a conventional (see PATENT LITERATURE 1, for example) flexible substrate is made of aluminum. The thermal conductivity of aluminum is 240 W/mK, which is less than 400 W/mK of the thermal conductivity of copper. Therefore, in order to obtain a desired heat dissipating property, the thickness has to be further increased.

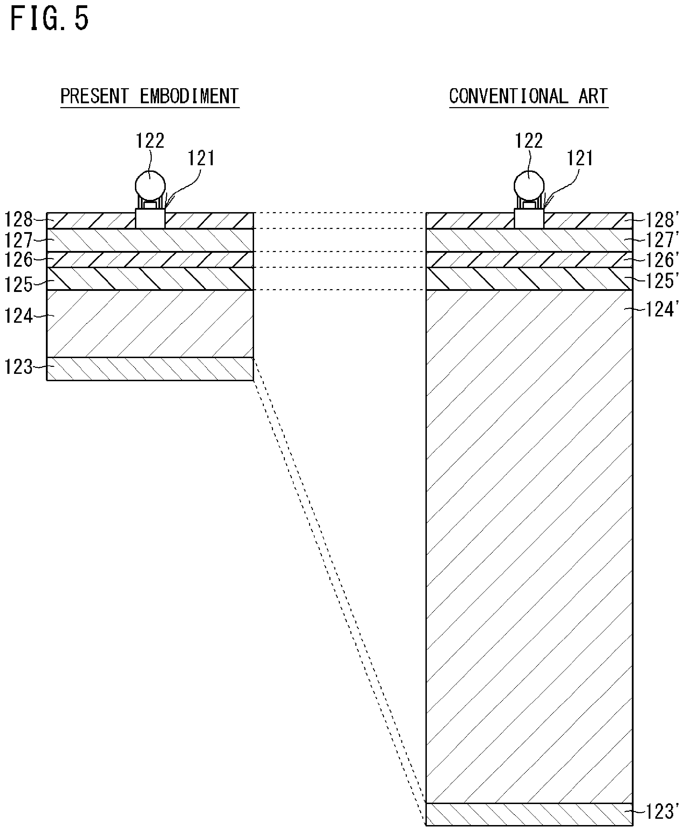

Specifically, the reinforcing plate 124 made of copper according to the present embodiment has a thickness of 105 µm, whereas the conventional reinforcing plate made of aluminum has a thickness of 800 µm. As a result, if it is assumed that the thicknesses of the layers except the reinforcing plate 124 are the same between the flexible printed circuit 12 according to the present embodiment and a conventional flexible printed circuit, the thickness of the flexible printed circuit 12 according to the present embodiment is about 1/5 of the thickness of the conventional flexible printed circuit. FIG. 5 is a visual expression of the difference in the thickness of the flexible printed circuit 12 between the present embodiment and the conventional art. In FIG. 5, the layers according to the conventional art that correspond to those according to the present embodiment are denoted by reference signs with "' ".

Meanwhile, the specific gravity of copper is about 9.0, which is greater than about 2.7 of the specific gravity of aluminum. However, the thickness (105 µm) of the reinforcing plate 124 according to the present embodiment is greatly reduced from the thickness (800 µm) of the conventional reinforcing plate made of aluminum. Thus, the weight of the reinforcing plate 124 according to the present embodiment is about half that of the conventional reinforcing plate. Therefore, in the reinforcing plate 124 according to the present embodiment, both the thickness and the weight are reduced compared with those in the conventional reinforcing plate, whereby the material cost can be reduced.

Since the thickness and the weight of the reinforcing plate 124 are reduced, the entirety of the flexible printed circuit 12 can be made thin and the weight thereof can be reduced. This further facilitates handling of the flexible printed circuit 12, and thus, workability in manufacturing the photovoltaic module can be improved.

The Mohs hardness of aluminum is about 2.5, whereas the Mohs hardness of copper is about 3.0, which is slightly greater than that of aluminum. However, the reinforcing plate 124 according to the present embodiment has a smaller thickness than the conventional reinforcing plate 124, and thus, the flexibility required for the flexible printed circuit 12 can be sufficiently ensured.

As shown in table 1, the thickness of the reinforcing plate 124 can be set in a range from 30 µm to 140 µm. This is because: if the thickness of the reinforcing plate 124 is smaller than 30 µm, the heat dissipating property and the effect of reinforcement are reduced; and if the thickness of the reinforcing plate 124 is greater than 140 µm, the effects of weight reduction, flexibility, and cost reduction of the flexible printed circuit 12 are reduced. In a case where weight reduction, flexibility, and cost reduction of the reinforcing plate 124 are important, it is more preferable that the thickness of the reinforcing plate 124 is set in a range from 30 µm to 110 µm.

The flexible printed circuit 12 is obtained in the following manner. That is, the reinforcing plate 124 is joined via the adhesive layer 125 to the insulating base material 126 having the pattern 127 formed thereon, and then, the resultant member is cut (stamped) into a predetermined shape (elongated ribbon shape) by use of a press or the like. Alternatively, the reinforcing plate 124 is joined to the insulating base material 126 having the pattern 127 formed thereon, and then, the power generating element 121 and the secondary concentrating portion 122 are mounted on the pattern 127, the adhesive layer 123 is mounted to the reinforcing plate 124, and then, the resultant member is cut into a predetermined shape.

In the present embodiment, since both the pattern 127 and the reinforcing plate 124 are made of copper, these can be cut on the substantially same condition. Thus, the insulating base material 126 having the pattern 127 formed thereon and the reinforcing plate 124 need not be separately cut, but can be cut at the same time in a state of being joined together. Accordingly, the number of manufacturing steps can be reduced when compared with a case where the insulating base material 126 having the pattern 127 formed thereon and the reinforcing plate 124 are separately cut.

The pattern 127 and the reinforcing plate 124 are made of an identical material, and the coefficients of thermal expansion thereof are also identical to each other. Thus, difference in thermal expansion caused when the pattern 127 and the reinforcing plate 124 are joined together by heat pressing, and variation in dimensions caused by difference in thermal shrinkage that occurs when the pattern 127 and the reinforcing plate 124 are joined and cooled are less likely to occur. Therefore, the dimensional accuracy of the product can be increased, defective products are reduced, and the yield can be improved.

Furthermore, in a case where the insulating base material 126 having the pattern 127 formed thereon and the reinforcing plate 124 are separately cut and then joined together by heat pressing, if the rigidity of the reinforcing plate 124 is low, appropriate joining thereof by heat pressing is difficult. However, in the present embodiment, since the insulating base material 126 having the pattern 127 formed thereon and the reinforcing plate 124 are joined together in advance and then cut, the rigidity required for the reinforcing plate 124 is reduced, and thus, the reinforcing plate 124 can be made thinner, accordingly. In addition, in the present embodiment, since the reinforcing plate 124 made of copper which has better workability than the conventional reinforcing plate made of aluminum, the life of a die used in the cutting can be extended. Moreover, thin copper plates are on the market in large quantities, cost can be suppressed.

With respect to the reinforcing plate 124, the surface on the adhesive layer 125 side has been subjected to blackening treatment, whereby fine bumps are formed on the surface. Thus, the adhesive force to the insulating base material 126 can be increased, and generation of bubbles can be suppressed. In the present embodiment, the adhesive force can be increased about 3 to 5 times. In addition, the surface on the adhesive layer 123 side of the reinforcing plate 124 is mirror-finished. It is sufficient that this surface has the same electric potential as that of the bottom plate 11a of the housing 11 via the adhesive layer 123, and thus, need not be subjected to blackening treatment.

In the above embodiment, the housing 11 is made of metal, but is not limited thereto. The housing 11 may be made of resin. In this case, the housing 11 becomes especially light in weight, and the entirety of the concentrated photovoltaic module 1M becomes especially light in weight. It should be noted that resin also has a certain thermal conductivity, and thus, a certain heat dissipating property can be obtained. In particular, a resin is suitable to which an insulating filler having a high thermal conductivity (for example, alumina, silica, silicon carbide, magnesium oxide, or the like) has been added, because such a resin is excellent in thermal conductivity and thus the heat dissipating property is improved. Further, by applying metal coating to the surface of the resin, the thermal conductivity of the surface can be increased so as to be equivalent to that of metal.

In the above embodiment, the secondary concentrating portion 122 is mounted on the flexible substrate 12f together with the power generating element 121. However, the secondary concentrating portion 122 can be provided separately from the flexible substrate 12f. Moreover, the secondary concentrating portion itself can be omitted.

The pattern 127 and the reinforcing plate 124 may be formed of a metal other than copper, as long as they are formed of the same material.

The recommended values and the applicable ranges of the layers shown in table 1 are merely examples. Not necessarily limited thereto, such recommended values and applicable ranges can be changed depending on the materials of the layers. In particular, with respect to the reinforcing plate, it is sufficient to set a thickness or a range that allows, in terms of heat dissipating property, weight reduction, flexibility, and cost, obtainment of a result that is substantially equivalent to the result of the conventional reinforcing plate made of aluminum, or obtainment of a result that is excellent in at least one of heat dissipating property, weight reduction, flexibility, and cost when compared with the conventional reinforcing plate made of aluminum.

It should be noted that the embodiment disclose herein is merely illustrative in all aspects and should not be recognized as being restrictive. The scope of the present invention is defined by the scope of the claims.

### REFERENCE SIGNS LIST

- 1: concentrated photovoltaic panel
- 1M: concentrated photovoltaic module
- 2: post
- 3: base
- 11: housing
- 11a: bottom plate
- 11b: flange portion
- 12: flexible printed circuit
- 12f: flexible substrate
- 13: primary concentrating portion
- 13f: Fresnel lens
- 14: connector
- 100: concentrated photovoltaic apparatus
- 121: power generating element
- 121a: lead frame
- 122: secondary concentrating portion
- 123: adhesive layer
- 123': adhesive layer
- 124: reinforcing plate (reinforcing layer)
- 124': reinforcing plate (reinforcing layer)
- 125: adhesive layer
- 125': adhesive layer
- 126: insulating base material (insulating layer)
- 126': insulating base material (insulating layer)
- 127: pattern (conductive layer)
- 127': pattern (conductive layer)
- 128: cover lay (protection layer)
- 128': cover lay (protection layer)

## Claims

1. A flexible printed circuit (12) for a concentrated photovoltaic module (1M) comprising:
a conductive layer (127) to which a power generating element (121) is connected;
an insulating layer (126) having an insulating property;
an adhesive layer (125); and
a reinforcing layer (124) for reinforcing the insulating layer (126);
the conductive layer (127), the insulating layer (126), the adhesive layer (125) and the reinforcing layer (124) being joined and stacked together in this order, wherein
the reinforcing layer (124) is formed of a material identical to that of the conductive layer (127),
one surface of the reinforcing layer (124) to be joined to the insulating layer (126) has been subjected to blackening treatment, whereby fine bumps are formed on the surface.

2. The flexible printed circuit (12) according to claim 1, wherein
the conductive layer (127) and the reinforcing layer (124) are made of copper.

3. The flexible printed circuit (12) according to claim 2, wherein
a thickness of the reinforcing layer (124) is set in a range from 30 to 140 µm.

4. The flexible (12) printed circuit according to any one of claim 1 to claim 3, wherein
a protection layer (128) covering a surface of the conductive layer (127) to which the power generating element (121) is connected is provided in a manner of avoiding the power generating element (121).

5. The flexible printed circuit (12) according to any one of claim 1 to claim 4, wherein
an adhesive layer (123) for joining the reinforcing layer (124) to a housing (11) of a concentrated photovoltaic module (1M) is provided on a surface of the reinforcing layer (124) opposite to the surface of the reinforcing layer (124) to which the insulating layer (126) is joined.

6. A concentrated photovoltaic module (1M) comprising:
a housing (11) having a mounting surface;
the flexible printed circuit (12) according to any one of claim 1 to claim 5 to be joined to the mounting surface; and
a lens element (13) mounted to the housing (11) so as to correspond to a power generating element (121) of the flexible printed circuit (12), the lens element (13) configured to concentrate sunlight on the power generating element (121).

7. A concentrated photovoltaic panel (1) formed by assembling a plurality of the concentrated photovoltaic modules (1M) according to claim 6.

8. A method for manufacturing a flexible printed circuit (12), the method comprising the steps of:
forming an intermediate material of a flexible printed circuit (12) for a concentrated photovoltaic module (1M), by joining and stacking a conductive layer (127) to which a power generating element (121) is connected, an insulating layer (126) having an insulating property, an adhesive layer (125) and a reinforcing layer (124) which is formed of a material identical to that of the conductive layer (127) and which is for reinforcing the insulating layer (126) and
cutting the intermediate material into a desired shape;
wherein one surface of the reinforcing layer (124) to be joined to the insulating layer (126) has been subjected to blackening treatment, whereby fine bumps are formed on the surface.

## Patentansprüche

1. Flexible gedruckte Schaltung (12) für ein konzentriertes Photovoltaikmodul (1M), die aufweist:
eine leitfähige Schicht (127), an die ein Stromerzeugungselement (121) angeschlossen ist;
eine Isolierschicht (126) mit einer isolierenden Eigenschaft;
eine Haftvermittlerschicht (125); und
eine Armierungsschicht (124) zur Verstärkung der Isolierschicht (126);
wobei die leitfähige Schicht (127), die Isolierschicht (126); die Haftvermittlerschicht (125) und die Armierungsschicht (124) zusammengefügt und gemeinsam in dieser Reihenfolge gestapelt sind, wobei
die Armierungsschicht (124) aus einem Material gebildet ist, das mit jenem der leitfähigen Schicht (127) identisch ist;
eine Oberfläche der Armierungsschicht (124), die an die Isolierschicht (126) angefügt werden soll, einer Schwärzungsbehandlung unterzogen wurde, wodurch auf der Oberfläche feine Unebenheiten gebildet sind.

2. Flexible gedruckte Schaltung (12) nach Anspruch 1, wobei
die leitfähige Schicht (127) und die Armierungsschicht (124) aus gebildet sind.

3. Flexible gedruckte Schaltung (12) nach Anspruch 2, wobei
eine Dicke der Armierungsschicht (124) in einem Bereich von 30 bis 140 µm eingestellt ist.

4. Flexible gedruckte Schaltung (12) nach einem der Ansprüche 1 bis 3, wobei eine Schutzschicht (128), die eine Oberfläche der leitfähigen Schicht (27) bedeckt, an die das Stromerzeugungselement (121) angeschlossen ist, derart vorgesehen ist, dass sie das Stromerzeugungselement (121) umgeht.

5. Flexible gedruckte Schaltung (12) nach einem der Ansprüche 1 bis 4, wobei
eine Haftvermittlerschicht (123) zum Anfügen der Armierungsschicht (124) an ein Gehäuse (11) eines konzentrierten Photovoltaikmoduls (1M) an einer Oberfläche der Armierungsschicht (124) gegenüberliegend der Oberfläche der Armierungsschicht (124) vorgesehen ist, an welche die Isolierschicht (126) angefügt ist.

6. Konzentriertes Photovoltaikmodul (1M), aufweisend:
ein Gehäuse (11) mit einer Montagefläche;
die flexible gedruckte Schaltung (12) nach einem der Ansprüche 1 bis 5, die an die Montagefläche angefügt werden soll; und
ein Linsenelement (13), das an das Gehäuse (11) montiert ist, um einem Stromerzeugungselement (121) der flexiblen gedruckten Schaltung (12) zu entsprechen, wobei das Linsenelement (13) eingerichtet ist, Sonnenlicht auf dem Stromerzeugungselement (121) zu konzentrieren.

7. Konzentriertes Photovoltaikpaneel (1), das durch Zusammenbau einer Vielzahl der konzentrierten Photovoltaikmodule (1M) nach Anspruch 6 gebildet ist.

8. Verfahren zur Herstellung einer flexiblen gedruckten Schaltung (12), wobei das Verfahren die folgenden Schritte umfasst:
Bilden eines Zwischenmaterials einer flexiblen gedruckten Schaltung (12) für ein konzentriertes Photovoltaikmodul (1M) durch Zusammenfügen und Stapeln einer leitfähigen Schicht (127), an die ein Stromerzeugungselement (121) angeschlossen ist, einer Isolierschicht (126), die eine isolierende Eigenschaft besitzt, einer Haftvermittlerschicht (125) und einer Armierungsschicht (124), die aus einem Material gebildet ist, das mit jenem der leitfähigen Schicht (127) identisch ist und zur Armierung der Isolierschicht (126) dient, und durch Zuschneiden des Zwischenmaterials in eine gewünschte Form;
wobei eine Oberfläche der Armierungsschicht (124), die an die Isolierschicht (126) angefügt werden soll, einer Schwärzungsbehandlung unterzogen wurde, wodurch auf der Oberfläche feine Unebenheiten gebildet werden.

## Revendications

1. Circuit imprimé flexible (12) pour un module photovoltaïque concentré (1M) comprenant :
une couche conductrice (127) à laquelle un élément de génération de puissance (121) est connecté ;
une couche isolante (126) ayant une propriété isolante ;
une couche adhésive (125) ; et
une couche de renforcement (124) pour renforcer la couche isolante (126) ;
la couche conductrice (127), la couche isolante (126), la couche adhésive (125) et la couche de renforcement (124) étant assemblées et empilées conjointement dans cet ordre, dans lequel
la couche de renforcement (124) est formée d'un matériau identique à celui de la couche conductrice (127),
une surface de la couche de renforcement (124) destinée à être assemblée à la couche isolante (126) a été soumise à un traitement de noircissement, de sorte que des bosses fines sont formées sur la surface.

2. Circuit imprimé flexible (12) selon la revendication 1, dans lequel la couche conductrice (127) et la couche de renforcement (124) sont constituées de cuivre.

3. Circuit imprimé flexible (12) selon la revendication 2, dans lequel une épaisseur de la couche de renforcement (124) est définie dans une plage de 30 à 140 µm.

4. Circuit imprimé flexible (12) selon l'une quelconque de la revendication 1 à la revendication 3, dans lequel
une couche de protection (128) recouvrant une surface de la couche conductrice (127) à laquelle l'élément de génération de puissance (121) est connecté est disposée de manière à éviter l'élément de génération de puissance (121).

5. Circuit imprimé flexible (12) selon l'une quelconque de la revendication 1 à la revendication 4, dans lequel
une couche adhésive (123) pour assembler la couche de renforcement (124) à un boîtier (11) d'un module photovoltaïque concentré (1M) est disposée sur une surface de la couche de renforcement (124) opposée à la surface de la couche de renforcement (124) à laquelle la couche isolante (126) est assemblée.

6. Module photovoltaïque concentré (1M) comprenant :
un boîtier (11) comportant une surface de montage ;
le circuit imprimé flexible (12) selon l'une quelconque de la revendication 1 à la revendication 5 destiné à être assemblé à la surface de montage ; et
un élément de lentille (13) monté sur le boîtier (11) de façon à correspondre à un élément de génération de puissance (121) du circuit imprimé flexible (12), l'élément de lentille (13) étant configuré pour concentrer la lumière du soleil sur l'élément de génération de puissance (121).

7. Panneau photovoltaïque concentré (1) formé par assemblage d'une pluralité des modules photovoltaïques concentrés (1M) selon la revendication 6.

8. Procédé de fabrication d'un circuit imprimé flexible (12), le procédé comprenant les étapes de :
formation d'un matériau intermédiaire d'un circuit imprimé flexible (12) pour un module photovoltaïque concentré (1M), par assemblage et empilage d'une couche conductrice (127) à laquelle un élément de génération de puissance (121) est connecté, une couche isolante (126) ayant une propriété isolante, une couche adhésive (125) et une couche de renforcement (124) qui est formée d'un matériau identique à celui de la couche conductrice (127) et qui est destinée à renforcer la couche isolante (126) et découpe du matériau intermédiaire en une forme souhaitée ;
dans lequel une surface de la couche de renforcement (124) destinée à être assemblée à la couche isolante (126) a été soumise à un traitement de noircissement, de sorte que des bosses fines sont formées sur la surface.
